(19) Europäisches Patentamt
European Patent Office
Office européen des brevets

(11) **EP 2 165 205 B1**

(12) **EUROPÄISCHE PATENTSCHRIFT**

(45) Veröffentlichungstag und Bekanntmachung des Hinweises auf die Patenterteilung:
**26.06.2013   Patentblatt 2013/26**

(51) Int Cl.:
*G01R 1/20* (2006.01)

(21) Anmeldenummer: 08707997.6

(86) Internationale Anmeldenummer:
**PCT/EP2008/050572**

(22) Anmeldetag: **18.01.2008**

(87) Internationale Veröffentlichungsnummer:
**WO 2009/010313 (22.01.2009 Gazette 2009/04)**

(54) **BESCHICHTETES KRAFTFAHRZEUGBATTERIESENSORELEMENT SOWIE VERFAHREN ZUR HERSTELLUNG EINES KRAFTFAHRZEUGBATTERIESENSORELEMENTES**

COATED MOTOR VEHICLE BATTERY SENSOR ELEMENT AND METHOD FOR PRODUCING A MOTOR VEHICLE BATTERY SENSOR ELEMENT

ÉLÉMENT CAPTEUR DE BATTERIE DE VÉHICULE AUTOMOBILE MUNI D'UN REVÊTEMENT ET PROCÉDÉ DE PRODUCTION D'UN ÉLÉMENT CAPTEUR DE BATTERIE DE VÉHICULE AUTOMOBILE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **13.07.2007   DE 102007033182**
**24.09.2007   PCT/EP2007/060104**

(43) Veröffentlichungstag der Anmeldung:
**24.03.2010   Patentblatt 2010/12**

(73) Patentinhaber: **Auto-Kabel Managementgesellschaft mbH**
**79688 Hausen i.W. (DE)**

(72) Erfinder:
• **GRONWALD, Frank**
**50181 Bedburg (DE)**
• **LIETZ, Franz-Josef**
**46049 Oberhausen-Lirich (DE)**

(74) Vertreter: **Cohausz & Florack**
**Patent- und Rechtsanwälte**
**Partnerschaftsgesellschaft**
**Bleichstraße 14**
**40211 Düsseldorf (DE)**

(56) Entgegenhaltungen:
| | |
|---|---|
| EP-A- 0 193 854 | EP-A- 1 028 436 |
| EP-A- 1 030 185 | DE-A1-102004 007 851 |
| DE-A1-102004 040 575 | DE-A1-102004 049 153 |
| DE-A1-102005 019 569 | |

• **DAVID W BRAUDAWAY: "Precision Resistors: A Review of Material Characteristics, Resistor Design, and Construction Practices" IEEE TRANSACTIONS ON INSTRUMENTATION AND MEASUREMENT, IEEE SERVICE CENTER, PISCATAWAY, NJ, US, Bd. 48, Nr. 5, Oktober 1999 (1999-10), XP011024838 ISSN: 0018-9456**

**Beschreibung**

Die Anmeldung betrifft ein Kraftfahrzeugbatteriesensorelement mit einem Widerstandselement und zumindest zwei auf dem Widerstandselement angeordneten, räumlich voneinander getrennten Kontakten. Darüber hinaus betrifft die Anmeldung ein Verfahren zur Herstellung eines solchen Kraftfahrzeugbatteriesensorelements.

In heutigen Kraftfahrzeugen nimmt die Anzahl der elektrischen Verbraucher ständig zu. Neben den wesentlichen Motorfunktionen, welche elektrisch versorgt werden, wie beispielsweise die des Starters, befinden sich in Fahrzeugen eine Vielzahl von Komfortverbrauchern, wie beispielsweise Klimaanlage, Navigationssystem, Bordcomputer, Unterhaltungselektronik und dergleichen. Die Vielzahl der Komfortverbraucher führt zu einer erhöhten Belastung der Kraftfahrzeugbatterie. Selbst im Stillstand des Kraftfahrzeugs wird Energie von der Batterie abgerufen. Dies führt dazu, dass die Batterie nicht mehr nur für die ursprünglichen Aufgaben der Versorgung des Starters mit Startstrom Verwendung findet, sondern die gesamte Elektronik im Fahrzeug mit Energie versorgt. Durch die Entladung der Batterie im Stillstand kann es dazu kommen, dass im Startfall nicht genügend Startstrom zur Verfügung steht, was verhindert werden muss.

Aus den zuvor genannten Gründen ist es notwendig, den Zustand einer Batterie sicher bestimmen zu können. Hierzu sind in der Vergangenheit eine Vielzahl von Kraftfahrzeugbatteriesensoren vorgeschlagen worden. Diese Kraftfahrzeugbatteriesensoren sind bevorzugt unmittelbar an den Batteriemessklemmen angeordnet.

So ist beispielsweise aus der EP 0 990 167, DE 10 2004 007 851 eine Batteriemessklemme bekannt, welche über einen Widerstand (Shunt) neben dem Strom im Energieleiter der Batterie auch die Spannung und/oder die Temperatur misst und beispielsweise anhand dieser Werte den Zustand der Batterie auswertet. Zur Auswertung des Batteriezustands ist es notwendig, die über den Shunt abfallende Spannung genau messen zu können. Die Auswertung ist stark abhängig von der Qualität des Spannungsabgriffes über dem Shunt. Somit kommt es für eine genaue Messung darauf an, wie die Spannungsabgriffe und die Messsensorik an dem Shunt angeordnet sind.

Bei den heutzutage bekannten Widerstandselementen ist es notwendig, ein Widerstandsstück zwischen zwei Anschlussstücken anzuordnen. So wird heutzutage beispielsweise eine CuMnl2Ni-Legierung (Manganin) als Widerstandsstück verwendet. Das Manganin wird zwischen zwei Anschlussstücken aus Nichteisenmetall, beispielsweise Kupfer, angeordnet. Bei der Herstellung werden beispielsweise die als Flachteile gebildeten Anschlussstücke mit dem als Flachteil gebildeten Widerstandsstück mittels Elektronenstrahlschweißen verschweißt. Das Flachteil aus Manganin kann dabei dünner sein, als die Flachteile der Anschlussstücke, so dass das Widerstandsstück eine Vertiefung der Oberfläche des Widerstandelements ausbildet. Auf den aus Kupfer gebildeten Anschlussstücken werden an Anschlusskonsolen, die ebenfalls aus Kupfer sind, angeordnet. Mit den Anschlusskonsolen wird ein integrierter Schaltkreis verlötet, mit welchem zumindest die physikalischen Größen Strom, Spannung und/oder Temperatur des Widerstandsstücks auswertbar sind.

Es ist jedoch erkannt worden DE 10 2005 019 569, DE 10 2004 049 153, dass in dem Übergang zwischen Kupfer und Manganin eine Thermospannung entsteht. Diese Thermospannung führt zu Beeinflussungen des Messergebnisses der Messelektronik. Verantwortlich für die Thermospannung ist beispielsweise der Seebeck-Effekt. So entsteht ein Strom innerhalb eines Leiters, wenn Wärme fließt. Für den Fall, dass die Anschlusskonsolen unmittelbar auf dem Manganin angeordnet sind, kommt es zu einer Thermospannung, welche das Messergebnis temperaturvariant beeinflusst. Die Thermospannung ist auch als Thermokraft bekannt und wird durch einen temperaturabhängigen Fluss von Elektronen verursacht. Die Thermospannung kann durch:

$$U = (K_a - K_b) \cdot (T_1 - T_2)$$

mit U: Spannung, K : K-Wert des Materials, $T_1$ ; $T_2$ : Temperatur der Materialien an der Verbindungsstelle bestimmt werden. Kupfer hat einen K-Wert von 0,7mV/100K.

Aus den zuvor gezeigten Nachteilen ergibt sich das Problem, ein Widerstandselement für einen Kraftfahrzeugbatteriesensor zur Verfügung zu stellen, welches im Wesentlichen temperaturinvariant ist.

Das zuvor aus dem Stand der Technik hergeleitete und aufgezeigte Problem wird durch die Merkmale des Anspruchs 1 gelöst. Das Widerstandselement ist zusammen mit den elektrischen Kontakten mit einer metallischen Beschichtung beschichtet.

Es ist erkannt worden, dass durch eine nahtlose metallische Beschichtung des Widerstandselements zusammen mit den elektrischen Kontakten der Einfluss der Thermospannung zwischen dem Widerstandselement und den elektrischen Kontakten auf das Messergebnis verringert, bevorzugt eliminiert werden kann.

Besteht zwischen den elektrischen Kontakten und dem Widerstandselement eine Thermospannung, kann diese durch die Beschichtung kurz geschlossen werden. Die elektrischen Kontakte können beispielsweise unmittelbar auf dem Shunt aufgebracht sein, wodurch eine temperaturabhängige Thermospannung zwischen dem Shunt und den Kontakten entsteht. Zur Kompensation dieser Übergangsspannung wird die metallische Beschichtung vorgesehen. Die metallische Beschichtung kann die Thermospannung elektrisch kurz schließen und somit deren Einfluss auf das Messergebnis kompensieren. Der elektrische Abgriff des Sensors erfolgt über die Kontakte. Am elektrischen Abgriff ist die Thermospannung zwischen dem Widerstand und den elektrischen Kontakten im Wesentlichen kompensiert.

Die metallische Beschichtung stellt im elektrischen Ersatzschaltbild einen parallel zur Messsensorik angeordnete Widerstand dar, welcher parallel zum Messwiderstand liegt. Der Einfluss des Widerstands der metallischen Beschichtung liegt beispielsweise im Bereich zwischen 1 und 3% des Gesamtwiderstandes des Messwiderstands.

Es hat sich gezeigt, dass eine Beschichtung aus Zinn (SN) die erforderlichen Eigenschaften aufweist. Durch die metallische Beschichtung wird außerdem ein Oberflächenschutz der Kontakte und des Widerstandselementes erreicht. Es ist bekannt, dass elektrische Kontakte oxidieren können und somit beim Abgriff über die elektrischen Kontakte ein erhöhter Übergangswiderstands auftritt. Durch die Verwendung der Beschichtung aus Zinn kann ein Oxidieren der elektrischen Kontakte verringert werden.

Die Thermospannung zwischen den elektrischen Kontakten und dem Widerstandselement bzw. zwischen den Anschlussstücken und dem Widerstandsstück des Widerstandselements kann zwischen 0,1

$$\frac{\mu V}{K} \text{ und } 10 \ \frac{\mu V}{K}, \text{ , bevorzugt zwischen } 0,4 \ \frac{\mu V}{K}$$

und 0,8 $\frac{\mu V}{K}$ liegen. Dies ist beispielsweise bei der Verwendung von Manganin als Widerstandsstück des Widerstandselements und Kupfer als elektrischer Kontakt bzw. Anschlussstück der Fall.

Eine Schichtdicke der Beschichtung von 1 $\mu$m bis 10 $\mu$m, bevorzugt 5 $\mu$m bis 8 $\mu$m, ist bevorzugt. Eine solche Beschichtung führt bei einem Abstand zwischen den elektrischen Kontakten von ca. 10mm zu einem Widerstand der Beschichtung zwischen den elektrischen Kontakten von ca. 8000 $\mu\Omega$. Für den Fall, dass der Widerstand des Widerstandsstücks, beispielsweise des Shunts, 110 $\mu\Omega$ ist, ergibt sich aus der Parallelschaltung dieser beiden Widerstände ein Gesamtwiderstand von 108,6 $\mu\Omega$.

Um Temperatureinflüsse auf das Messergebnis verringern zu können, wird vorgeschlagen, dass der temperaturabhängige Widerstand der Beschichtung durch den temperaturabhängigen Widerstand des Widerstandselements im Wesentlichen kompensiert ist. Bei der Verwendung von Zinn kann beispielsweise durch die temperaturabhängige Veränderung des Widerstands (Temperaturkoeffizient) der Beschichtung das Messergebnis verfälscht werden. Bei einem Präzisionsmesswiderstand ist dies jedoch nachteilig. Daher kann durch eine geeignete Wahl des Widerstandselements der temperaturabhängigen Verränderung des Widerstands der Beschichtung entgegen gewirkt werden. Beispielsweise kann das Widerstandelement so gewählt werden, dass der Gesamtwiderstand aus Parallelschaltung zwischen Beschichtung und Widerstandselement im wesentlichen temperaturenabhängig ist.

Beispielsweise kann der Temperaturkoeffizient $\alpha_{20}$ der Beschichtung im Bereich von $1 \cdot 10^{-3}$ bis $9 \cdot 10^{-3}$l/K, bevorzugt $6 \cdot 10^{-3}$ l/K liegen. Der Temperaturkoeffizient $\alpha_{20}$ des Widerstandselementes kann beispielsweise hierzu invers sein. Auch kann der Temperaturkoeffizient $\alpha_{20}$ des Widerstandselementes bei $10 \cdot 10^{-6}$ 1/K liegen.

Die elektrischen Kontakte können unmittelbar auf einem Widerstandsstück, welches beispielsweise aus Manganin gebildet ist, des Widerstandselements angeordnet sein. Bei Temperaturveränderungen ändern sich die Widerstände abhängig vom Temperaturkoeffizienten entsprechend:

$$R(T) = R(T_0)(1 + \alpha_{T0}(T - T_0))$$

mit R:Widerstand, T:Temperatur, $T_0$:Anfangstemperatur, bevorzugt 20°C, $\alpha_{T0}$:Temperaturkoeffizient bei Anfangstemperatur.

Gemäß eines vorteilhaften Ausführungsbeispiels sind die elektrischen Kontakte aus einem Nichteisenmetall, beispielsweise Kupfer, gebildet. Die Kupferkontakte ermöglichen eine gute Kontaktierung mit einer Messsensorik zur Messung des Batteriestroms und/oder der Temperatur.

Das Widerstandselement kann gemäß eines vorteilhaften Ausführungsbeispiels aus zwei stoffschlüssige miteinander verbundenen Flachteilen gebildet sein. Beispielsweise kann ein Widerstandsstück aus Manganin gebildet sein und ein Anschlussstück aus Kupfer gebildet sein.

Gemäß eines vorteilhaften Ausführungsbeispiels ist das erste Flachteil ein als Messwiderstand gebildetes Widerstandsstück und ein zweites Flachteil ein aus Nichteisenmetall gebildetes Anschlussstück.

Durch das Aufbringen der Kontakte flächig auf der Oberfläche des Widerstandselementes dienen die Kontakte unmittelbar als Abstandhalter für einen integrierten Schaltkreis, so dass eine Kontaktierung zwischen integriertem Schaltkreis und Widerstandselement außerhalb der Kontakte vermieden werden kann. Dadurch, dass das Widerstandselement als Flachteil gebildet ist, können die Kontakte entlang der Oberfläche des Widerstandselements flächig angeordnet sein.

Bevorzugt wird die Verwendung der Materialien NiCu30Fe, CuMnl2Ni, CuNi30Mn, NiFe30, CuNi23Mn, CuMn7Sn, CuNi15, CuNi10, CuMn3, CuNi6, Ni99,6, Ni99,4Fe, Ni99,98, CuNi2, CuNi1, E-Cu57 oder W. Diese Legierungen oder Materialien eignen sich in besonderem Maße als Widerstandselement, da sie eine genaue Bestimmung der Spannung und der Stroms erlauben.

Um unmittelbar die Temperatur der Batterie messen zu können, wird vorgeschlagen, dass das Widerstandselement stoffschlüssig mit einer Batteriepolklemme verbunden ist. In diesem Falle ist die Batteriepolklemme unmittelbar an einen Batteriepol anschließbar und die Temperatur des Batteriepols überträgt sich auf das Widerstandselement.

Um die elektrischen Verbraucher des Kraftfahrzeugs mit dem Batteriestrom versorgen zu können, wird vorgeschlagen, dass das Widerstandselement stoffschlüssig mit einem zur Verbraucher führenden Energieleiter verbunden ist.

Gemäß eines vorteilhaften Ausführungsbeispiels wird vorgeschlagen, dass die Kontakte aus flächig auf der Oberfläche des Widerstandselements angeordneten flachen oder runden elektrischen Leitern gebildet sind. Beispielsweise ist es möglich, einen Runddraht entlang der Oberfläche des Flachteils anzuordnen und elektrisch mit dem Widerstandselement zu verbinden. Liegen die Kontakte in einem definierten Abstand zueinander, so ist es möglich, über die zwischen den Kontakten gemessene Spannung den Stromfluß im Widerstandselement bestimmen zu können. Durch eine große Auflagefläche zwischen den Kontakten und dem Widerstandselement ist es möglich, eine genaue Temperatursensierung in einem mit den Kontakten verbundenen integrierten Schaltkreis zu gewährleisten. Es ist auch möglich, dass Flachprofile als Leiter mit dem Widerstandselement kontaktiert werden, um die Kontakte zu bilden.

Auch wird vorgeschlagen, dass die Kontakte im Wesentlichen orthogonal zur Stromausbreitungsrichtung im Widerstandselement auf der Oberfläche des Widerstandselements angeordnet sind. Die flächige Anordnung der Kontakte auf dem Widerstandselement kann im Wesentlichen entlang einer Linie erfolgen. Eine flächige Anordnung der Kontakte auf dem Widerstandselement bietet im Gegensatz zu einer punktuellen Anordnung neben einem geringen Übergangswiderstand und guter thermischer Leitfähigkeit auch eine Stützfunktion für einen auf den Kontakten aufgebrachten integrierten Schaltkreis.

Um einen guten elektrischen Kontakt zwischen Widerstandselement und Kontakt herzustellen, wird vorgeschlagen, dass die Kontakte stoffschlüssig mit dem Widerstandselement verbunden sind.

Eine derartige stoffschlüssige verbindung kann beispielsweise mittels Ultraschallschweißen hergestellt werden. Beim Ultraschallschweißen wird vermieden, dass Materialspritzer auf das Widerstandselement spritzen und somit die Messergebnisse eventuell verfälschen. Eine gute elektrische Kontaktierung und eine hohe mechanische Tragfähigkeit der Kontakte für einen integrierten Schaltkreis wird dadurch erreicht, dass die Kontakte im Wesentlichen flächig entlang ihrer Ausbreitungsrichtung mit dem Widerstandselement verbunden sind.

Es ist nicht notwendig, dass die flächig auf dem Flachteil aufliegenden Kontakte entlang der gesamten Auflagefläche elektrisch mit dem Widerstandselement kontaktiert werden. Es ist auch möglich, dass die Kontakte lediglich punktuell stoffschlüssig mit dem Widerstandselement verbunden werden.

Eine möglichst große Auflagefläche zwischen Kontakten und Widerstandselementen wird dadurch gewährleistet, dass die Kontakte auf der breiten Oberfläche des als Flachteil gebildeten Widerstandselements angeordnet sind.

Eine besonders einfache Kontaktierung eines integrierten Schaltkreises mit den Kontakten wird dadurch gewährleistet, dass die Kontakte an ihren beiden Enden derart gebogen sind, dass Kontaktstifte im Wesentlichen orthogonal aus der Oberflächenebene des Widerstandselements ragen. Beispielsweise ist es möglich, beim Herstellen die Kontakte über die Kanten des Widerstandselementes herausragen zu lassen. So ist es beispielsweise möglich, die Kontakte, die beispielsweise als Drähte gebildet sind, derart abzulängen, dass deren Länge geringfügig größer ist, als die Breite des Widerstandselements. Die Enden der Drähte stehen nach dem stoffschlüssigen Verbinden mit dem Widerstandselement über die Kanten des Widerstandselements ab. In einem weiteren Fertigungsschritt kann das mit den Kontakten verbundene Widerstandselement beispielsweise in eine Formgebungsmatrix gedrückt werden, welche die über die Kanten hinausstehenden Teile der Kontakte aus der Ebene der Oberfläche des Widerstandselements herausdrückt. Die so gebildeten Kontaktstifte ragen aus der Ebene des Widerstandselements heraus und eignen sich in besonderer Weise für eine elektrische Kontaktierung mit einem integrierten Schaltkreis.

Die Kontakte dienen zur Kontaktierung mit einem integrierten Schaltkreis, so dass mit Hilfe des integrierten Schaltkreises zumindest die elektrische Spannung zwischen den Kontakten ausgewertet werden kann.

Durch das flächige Aufbringen der Kontakte auf dem Widerstandselement bilden die Kontakte einen natürlichen Abstandhalter. Ein auf den Kontaktstiften aufgebrachter integrierter Schaltkreis wird durch die Kontakte vor einer mechanischen Kontaktierung mit dem Widerstandselement geschützt. Im Bereich der Kontakte kann die integrierte Schaltung so gebildet sein, dass die den Kontakten zugewandte Seite frei von Lötpunkten ist, so dass lediglich die Platine der integrierten Schaltung auf den Kontakten aufliegt und somit eine elektrische Kontaktierung mit Elementen der integrierten Schaltung vermieden wird.

Die elektrischen Kontakte haben bevorzugt ein Abstand von 1 bis 50mm, vorzugsweise 5-10mm. Hierdurch lässt sich der Batteriestrom gut bestimmen.

Es ist auch möglich, dass das Widerstandselement aus zumindest zwei elektrischen Anschlussstücken und einem Widerstandsstück gebildet ist. Die elektrischen Anschlussstücke können beispielsweise aus einem Nichteisenmetall, beispielsweise Kupfer oder Aluminium oder Legierung hieraus gebildet sein. Durch das Anordnen von Anschlussstücken ist es eventuell leichter, einen elektrischen Übergang mit dem Energieleiter des Bordnetzes zur Verfügung zu stellen, da mit Hilfe der Anschlussstücke ein Kabelschuh oder eine andere Aufnahme für den Energieleiter geschaffen werden kann.

Die Kontakte können gemäß eines vorteilhaften Ausführungsbeispiels entweder im Bereich des Widerstandsstücks selbst, auf den Übergängen zwischen dem Widerstandsstück und den Anschlussstücken oder auf den Anschlussstücken angeordnet sein.

Eine günstige Herstellung des Widerstandselements ist dadurch gewährleistet, dass das Widerstandselement aus von Stangen gestanzten oder geschnittenen Flachteilen gebildet ist. Werden die Widerstandselemente aus Stangenware hergestellt, so entfällt ein Tempern, (Entspannen) da anderenfalls, wenn das Material der Widerstandselemente von einem Coil abgewickelt worden wäre, Spannungen im Widerstandselement entstünden.

Für den Fall, dass das Material der Widerstandselemente von einem Coil verarbeitet wird, wird gemäß eines vorteilhaften Ausführungsbeispiel vorgeschlagen, dass das Widerstandselement aus einem zunächst von einem Coil abgewickelten, dann gestanzten oder geschnittenen und abschließend getemperten Flachteil gebildet ist.

Ein weiterer Gegenstand der Anmeldung ist ein Verfahren zur Herstellung eines solchen Kraftfahrzeugbatteriesensorelementes nach Anspruch 12.

Das Verfahren weist die Schritte des Anordnens zweier räumlich voneinander getrennter elektrischer Kontakte auf einem Widerstandselement auf. Ferner werden die elektrischen Kontakte mit dem Widerstandselement elektrisch verbunden. Schließlich werden die elektrischen Kontakte zusammen mit dem Widerstandselement metallisch beschichtet. Die metallische Beschichtung kann beispielsweise aus Zinn sein.

Nachfolgend wird der Gegenstand der Anmeldung anhand einer Ausführungsbeispiele zeigenden Zeichnung näher erläutert. In der Zeichnung zeigen:

Fig. 1a     eine Ansicht eines herkömmlichen Widerstandselements;

Fig. 1b     eine Schnittansicht eines herkömmlichen Widerstandselements;

Fig. 2     eine Schnittansicht eines anmeldungsgemäßen Widerstandselements;

Fig. 3     eine Draufsicht auf ein anmeldungsgemäßes Widerstandselement;

Fig. 4     eine Schnittansicht eines Widerstandselements mit einer integrierten Schaltung.

Fig. 5     ein elektrisches Ersatzschaltbild einer Anordnung gemäß Figur 4;

Fig. 6     einen schematischen Verlauf der Widerstände in Abhängigkeit von der Temperatur.

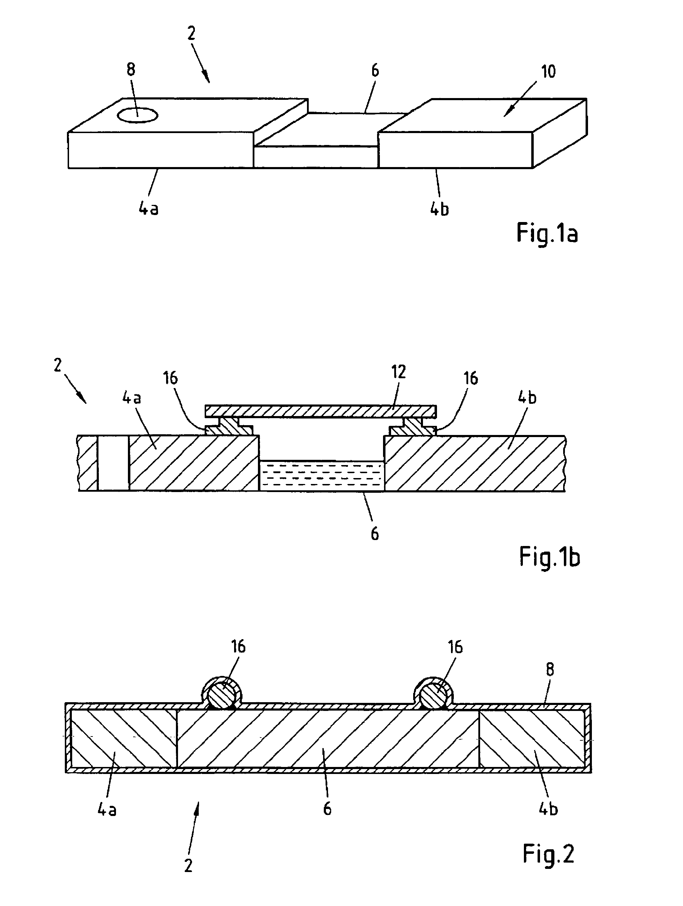

Fig. 1 zeigt ein Widerstandelement 2 mit zwei Anschlussstücken 4a, 4b und einem Widerstandsstück 6. Die Anschlussstücke 4a, 4b können beispielsweise aus Kupfer oder Legierungen davon gebildet sein. Das Widerstandsstück 6 kann aus einem Widerstandsmaterial, beispielsweise Manganin, wolfram, Zeranin oder dergleichen gebildet sein. Zwischen den Anschlusstücken 4a, 4b und dem Widerstandsstück 6 besteht eine stoffschlüssige Verbindung. Das Widerstandsstück 6 ist derart gebildet, dass es mit der Oberfläche der Anschlussstücke 4a, 4b eine Stufe bildet. Dies kann beispielsweise dadurch geschehen, dass ein Widerstandsstück 6 mit geringerer Stärke als die Anschlussstücke 4a, 4b mit den Anschlussstücken 4a, 4b stoffschlüssig verbunden wird. Die Anschlussstücke 4a, 4b können Aufnahmen 8 für Energieleiter aufweisen. Die Anschlussstücke 4a, 4b können derart geformt sein, dass sie eine Batterieklemme bilden und einen Anschluss an einen Energieleiter in einem Kraftfahrzeug ermöglichen.

Die durch das Widerstandsstück 6 gebildete Stufe in der Oberfläche 10 des Widerstandselements 2 wird verwendet, um, wie in Figur 1b gezeigt, einen ausreichenden Abstand zwischen einer integrierten Schaltung 12 und dem Widerstandsstück 6 zu gewährleisten. Die integrierte Schaltung 12 ist mittels Kontakte, wie in Figur 1b gezeigt, elektrisch mit den Anschlussstücken 4a, 4b kontaktiert. Die Kontakte 16 sind punktuell auf der Oberfläche 10 des Widerstandselements 2 angeordnet. Über die Kontakte 16 lässt sich die über das Widerstandsstück 6 abfallende Spannung messen. Auch erlauben die Kontakte 16 ein Abgreifen der Temperatur der Anschlussstücke 4a, 4b, welche neben anderen physikalischen Größen in der integrierten Schaltung 12 ausgewertet wird. An den elektrischen Übergängen zwischen den Anschlussstücken 4a, 4b und den Widerstandsstück 6 entsteht eine Thermospannung, welche die über die Kontakte 16 abgegriffene Spannung beeinflusst. Über die Kontakte 16 soll mittels der integrierten Schaltung 12 der Batteriestrom, der entlang des Anschlussstückes 4a, des Widerstandsstücks 6 und dem Anschlussstück 4b fließt, gemessen werden. Dieser Batteriestrom verursacht einen Spannungsabfall über dem Widerstandsstück 6, welcher durch die integrierte Schaltung 12 gemessen wird. Durch die an den Übergängen zwischen Anschlussstücken 4a, 4b und Widerstandsstück 6 entstehende Thermospannung wird neben der eigentlichen durch den Batteriestrom verursachten Spannung im Widerstandsstück 6 eine weitere Spannung gemessen. Die Thermospannung ist jedoch temperaturvariant, so dass bei ein und demselben Batteriestrom bei unterschiedlichen Temperaturen unterschiedliche Spannungen in der integrierten Spannung 12 gemessen werden. Dies führt zu einem verfälschten Messergebnis. Da, wie zuvor aufgezeigt worden ist, die Messung des Batteriestromes für die Funktion eines Kraftfahrzeugs eine bedeutende Rolle spielt, können durch Thermospannungen verursachte Ungenauigkeiten in dem Messergebnis zu Fehlfunktionen führen.

Figur 2 zeigt eine Schnittansicht eines Widerstandselements 2, bei welchem die zuvor erwähnten Probleme nicht auftreten. Figur 2 zeigt Anschlussstücke 4a, 4b, welche stoffschlüssig mit dem Widerstandsstück 6 verbunden sind. Es wird darauf hingewiesen, dass die Verwendung der Anschlusstücke 4 rein illustrativ ist. Ein Widerstandselement kann auch nur aus dem Widerstandsstück 6 oder dem Widerstandsstück 6 und einem Anschlusstück 4 gebildet sein. Auf dem Widerstandsstück 6 sind die elektrischen Kontakte 16 angeordnet. In der gezeigten Ausführungsform sind die Anschlussstücke 4a, 4b aus Kupfer gebildet und die Kontaktelemente 16 sind ebenfalls aus Kupfer gebildet. Das Widerstandsstück 6 ist als Shunt gebildet und kann beispielsweise aus Manganin sein. Zwischen Kupfer und Manganin entsteht eine Thermospannung aufgrund unterschiedlicher K-Werte. Das bedeutet, dass mit Temperaturveränderungen die Übergangsspannung zwischen den Anschlussstücken 4a, 4b und dem Widerstandsstück 6 bzw. dem Widerstandsstück 6 und den Kontaktelementen 16 sich verändert. Bei konstantem Strom durch das Widerstandsstück 6 wird über die Kontaktelemente 16 bei Temperaturveränderungen eine veränderte Spannung gemessen. Um diese Temperaturvarianz auszugleichen, wird vorgeschlagen, eine metallische Beschichtung 8, die beispielsweise aus Zinn gebildet sein kann, vorzusehen. Die metallische Beschichtung 8 umschließt das Widerstandselement 2 und gleichsam die Kontaktelemente 16 nahtlos. Durch eine geeignete Beschichtung 8 kann die Thermospannung des Übergangs von Widerstandsstück 6 zu den Kontaktelementen 16 bzw. Anschlussstücken 4 im Wesentlichen kurz geschlossen werden.

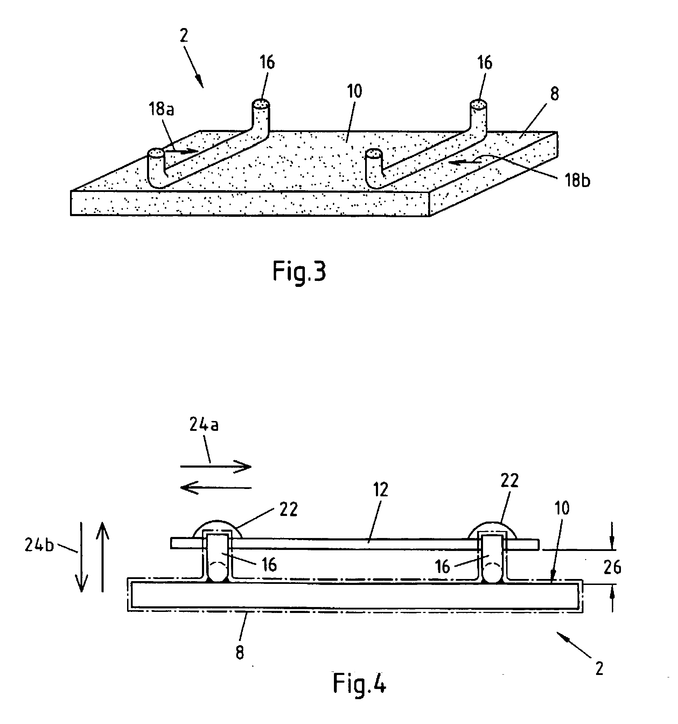

Figur 3 zeigt ein Widerstandselement 2 gemäß eines Ausführungsbeispiels. Zu erkennen ist, dass die Kontakte 16 auf der Oberfläche 10 des Widerstandselements 2, welches gemäß des gezeigten Ausführungsbeispiels als einziges Widerstandsstück 6 gebildet ist, angeordnet sind. Durch Pfeile 18 sind die beiden möglichen Stromflussrichtungen im Widerstandselement 2 angedeutet. Der Strom fließt durch das Widerstandselement 2 in Richtung des Pfeils 18a oder in Richtung des Pfeils 18b. Zu erkennen ist, dass die flächig auf dem Widerstandselement 2 angeordneten Kontakte 16 orthogonal zu der Stromflussrichtung auf der Oberfläche 10 des Widerstandselements 2 angeordnet sind. Die Kontakte 16 sind bevorzugt mittels Ultraschalschweißen auf der Oberfläche 10 des Widerstandselements 2 aufgebracht. Die Kontakte 16 sind bevorzugt als Drähte gebildet, können jedoch auch als Profilleiter mit einem rechteckigen oder quadratischen Querschnitt gebildet sein. Wie zu erkennen ist, sind die Kontakte 16 vorzugsweise bündig mit den Kanten des Widerstandselements 2. Die Kontakte 16 sind auf der Oberfläche 10, welches die breite Oberfläche des Widerstandselements 2 ist, angeordnet.

Entlang ihrer Ausbreitungsrichtung sind die Kontakte 16 mit der Oberfläche 10 des Widerstandselements 2 verbunden. Über die Kontakte 16 kann eine integrierte Schaltung 12 mit dem Widerstandselement 2 verbunden werden.

Eine besonders gute Kontaktierung einer integrierten Schaltung 12 mit dem Widerstandselement 2 ist beispielsweise dann möglich, wenn die Kontakte 16, wie in Figur 3 gezeigt, an den Kanten des Widerstandselements 2 gebogen sind, derart, dass die Enden der Kontakte 16 aus der Ebene der Oberfläche 10 des Widerstandselements 2 herausragen.

In der Figur 3 ist ebenfalls zu erkennen, dass das gesamte widerstandselement zusammen mit den Kontakten 16 mit der Beschichtung 8 beschichtet ist. Durch die Beschichtung 8 wird erreicht, dass Temperaturänderungen wenn überhaupt nur geringe Einflüsse auf das Messergebnis des Batteriestroms hat.

Figur 4 zeigt eine Seitenansicht eines Widerstandselements 2 mit einer integrierten Schaltung 12. Das Widerstandselement 2 ist über die Kontakte 16 mit der integrierten Schaltung 12 kontaktiert. Die Kontakte 16 sind mit dem integrierten Schaltkreis 12 über Lötpunkte 22 verbunden. Die Kontakte 16 sind an ihren Enden gebogen, so dass Kontaktstifte entstehen, über welche der integrierte Schaltkreis 12 mit dem Widerstandselement 2 elektrisch verbunden ist. Dadurch, dass die Kontaktstifte der Kontakte 16 aus der Ebene 10 des Widerstandselements 2 herausragen, können Kräfte 24, welche auf die integrierte Schaltung 12 oder das Widerstandselement 2 wirken, zwischen Widerstandselement 2 und integrierter Schaltung 12 ausgeglichen werden. Die Kontaktstifte dienen somit als Federelemente, welche Kräfte aufnehmen können. Wie zu erkennen ist, ist der Abstand 26 zwischen der integrierten Schaltung 12 und dem Widerstandselement 2 durch den Durchmesser der Drähte der Kontakte 16 bestimmt. Die Drähte der Kontakte 16 dienen somit als Abstandhalter zwischen Widerstandselement 2 und integrierter Schaltung 12.

Die Kontaktierung des integrierten Schaltkreises 12 über die Lötpunkte 22 weist gemäß der vorteilhaften Ausführungsform keine Temperaturspannung auf. Die Lötpunkte 22 sind bevorzugt aus Zinn gebildet, so wie die Beschichtung 8 auf der Oberfläche 10 des Widerstandselements 2. Die Beschichtung 8 ist ebenfalls auf den Kontakten 16 vorgesehen, so dass die Lötpunkte 22 auf einer Zinnoberfläche angeordnet sind. Bei der Messung des Stroms durch das Widerstandselement 2 wird eine Spannung zwischen den Kontakten 16 abgegriffen. Diese Spannung ergibt sich aus dem Strom durch das Widerstandselement 2 und dem Widerstand zwischen den Kontakten 16 des Widerstandselements 2. Herkömmlicherweise ist der Widerstand im Bereich von 50 bis 500 $\mu\Omega$, bevorzugt 110 $\mu\Omega$. Am Übergang zwischen dem Widerstandsstück 2 und den Kontakten 16 entsteht eine Thermospannung. Um diese Thermospannung zu unterdrücken, ist die Beschichtung 8 vorgesehen. Durch die Beschichtung 8 wird die Thermospannung zwischen den Kontakten 16 und dem Widerstandselement 2 im Wesentlichen kurz geschlossen.

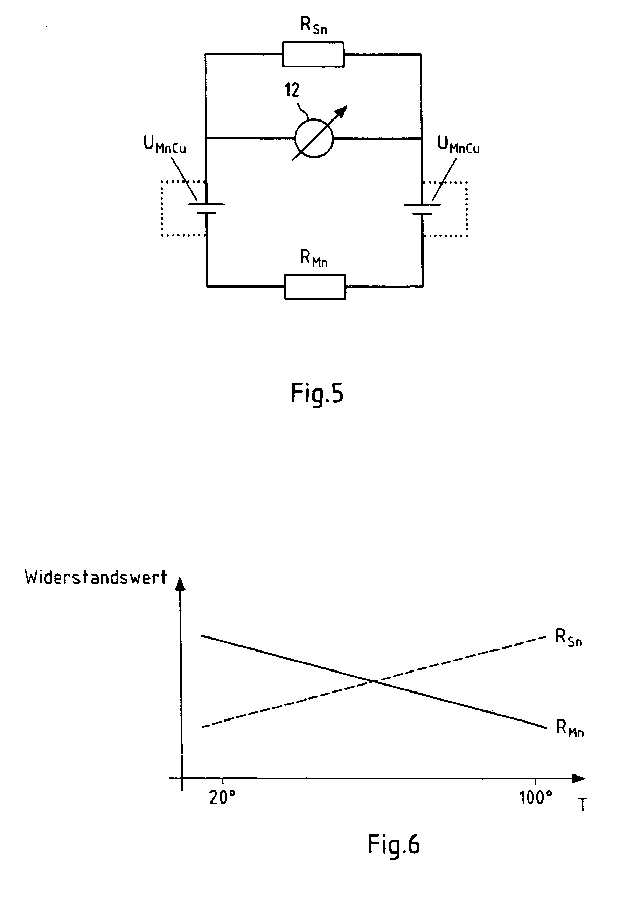

Figur 5 zeigt ein elektrisches Ersatzschaltbild eines Schaltungsanordnung gemäß Figur 4. Gezeigt ist ein Messwiderstand $R_{Mn}$, welcher der Widerstand des Widerstandselement 2 zwischen den Kontakten 16 ist. Ferner ist ein Widerstand $R_{Sn}$ gezeigt, welcher der Widerstand der Beschichtung 8 zwischen den Lötpunkten 22 ist. In Reihe mit dem Messwiderstand $R_{Mess}$ sind die Thermospannungen $U_{MnCu}$ dargestellt. Die Thermospannung $U_{MnCu}$ ist temperaturabhängig und ergibt sich aus den unterschiedlichen K-Werten des aus Manganin gebildeten Widerstandselements 2 und den aus Kupfer gebildeten Kontakten 16 sowie einer möglichen Temperaturdifferenz. Bei der Messung der Spannung über dem Messwiderstand $R_{Mess}$ mit Hilfe der integrierten Schaltung 12 entstehen parasitäre Effekte durch die Thermospannung $U_{MnCu}$.

Durch die durch eine punktierte Linie angedeutete Überdrückung der Spannung $U_{MnCu}$ durch die Beschichtung 8 werden diese Effekte minimiert oder eliminiert.

Die Widerstände $R_{Mn}$ und $R_{Sn}$ sind ebenfalls temperaturabhängig. Diese Abhängigkeit wird durch deren Temperaturkoeffizienten $\alpha$ bestimmt. Um auch diese Temperaturabhängigkeit zu kompensieren, wird vorgeschlagen, die Beschichtung 8 und das Widerstandsstück mit entsprechenden Temperaturkoeffizienten zu wählen, dass sich die Veränderungen der Widerstände abhängig von der Temperatur möglichst kompensieren.

Figur 6 zeigt rein illustrativ und schematisch den Temperaturverlauf des Widerstands $R_{Mn}$ sowie den Temperaturverlauf des Widerstands $R_{Sn}$. Die Darstellung soll lediglich zum Ausdruck bringen, dass die Temperaturkoeffizienten der beiden Widerstände im Wesentlichen so gewählt werden, dass die temperaturabhängigen Verläufe der Widerstände $R_{Mn}$ und $R_{Sn}$ im wesentlichen gegenläufig sind, so dass bei einer Parallelschaltung der Widerstände $R_{Mn}$ und $R_{Sn}$ im wesentlichen der Gesamtwiderstand gleich bleibt.

Durch die gezeigte Beschichtung des Widerstandselements werden temperaturbedingte Messfehler im Wesentlichen ausgeschaltet bzw. verringert, so dass die Messgenauigkeit eines Kraftfahrzeugbatteriesensorelementes erhöht wird.

**Patentansprüche**

1. Kraftfahrzeugbatteriesensorelement mit

   - einem Widerstandselement (2), und
   - zumindest zwei auf dem Widerstandselement (2) angeordneten, räumlich voneinander getrennten elektrischen Kontakten (16),

   wobei

   - das Widerstandselement (2) zusammen mit den elektrischen Kontakten (16) mit einer metallischen Beschichtung (8) beschichtet ist, derart,
   - dass die Thermospannung zwischen den elektrischen Kontakten (16) und dem Widerstandselement (2) über die Beschichtung (8) kurz geschlossen ist.

2. Kraftfahrzeugbatteriesensorelement nach Anspruch 1, **dadurch gekennzeichnet, dass** die Beschichtung (8) aus Zinn ist, und/oder dass die Beschichtung (8) eine Dicke von 1μm bis 10μm hat.

3. Kraftfahrzeugbatteriesensorelement nach Anspruch 1 oder 2, **dadurch gekennzeichnet, dass** die Thermospannung zwischen den elektrischen Kontakten (16) und dem Widerstandselement (2) zwischen 0,1 $\mu V/K$ und 1 $\mu V/K$ liegt, und/oder dass das Widerstandselement (6) im Temperaturbereich von 20°C bis 50°C einen Temperaturkoeffizienten im Bereich von $10 \cdot 10^{-6}$ hat, und/oder dass das Widerstandselement (2) einen den Temperaturkoeffizienten der Beschichtung (8) kompensierenden Temperaturkoeffizienten hat derart, dass der Einfluss des Temperaturkoeffizienten der Beschichtung auf den Gesamtwiderstand im Wesentlichen kompensiert ist.

4. Kraftfahrzeugbatteriesensorelement nach einem der vorangehenden Ansprüche, **dadurch gekennzeichnet, dass** die elektrischen Kontakte (16) aus einem Nichteisenmetall, insbesondere Kupfer, gebildet sind.

5. Kraftfahrzeugbatteriesensorelement nach einem der vorangehenden Ansprüche, **dadurch gekennzeichnet, dass** das Widerstandselement (2) aus zwei stoffschlüssig miteinander verbundenen Flachteilen (4, 6) gebildet ist, und/oder dass ein erstes Flachteil ein als Messwiderstand gebildetes Widerstandsstück (6) ist und ein zweites Flachteil ein aus Nichteisenmetall gebildetes Anschlussstück (4a, 4b) ist.

6. Kraftfahrzeugbatteriesensorelement nach einem der vorangehenden Ansprüche, **dadurch gekennzeichnet, dass** das Widerstandselement (2) zumindest teilweise aus NiCu30Fe, CuMn12Ni, Cu, Ni30Mn, NiFe30, CuNi23Mn, CuMn7Sn, CuNi15, CuNi10, CuMn3, CuNi6, Ni99,6, Ni99,4Fe, Ni99,98, CuNi2, CuNi1, E-Cu57 oder W gebildet ist.

7. Kraftfahrzeugbatteriesensorelement nach einem der vorangehenden Ansprüche, **dadurch gekennzeichnet, dass** das Widerstandselement (2) stoffschlüssig mit einer Batteriepolklemme verbunden ist, und/oder dass das - Widerstandselement (2) stroffschlüssig mit einem zu Verbrauchern führenden Energieleiter verbunden ist.

8. Kraftfahrzeugbatteriesensorelement nach einem der vorangehenden Ansprüche, **dadurch gekennzeichnet, dass** die elektrischen Kontakte (16) aus flächig auf der Oberfläche des Widerstandselements (2) angeordneten, flachen oder runden Leitern gebildet ist, und/oder dass die elektrischen Kontakte (16) im Wesentlichen orthogonal zur Stromausbreitungsrichtung im Widerstandselement (2) auf der Oberfläche (10) des Widerstandselement (2) angeordnet sind.

9. Kraftfahrzeugbatteriesensorelement nach einem der vorangehenden Ansprüche, **dadurch gekennzeichnet, dass** die Enden der elektrischen Kontakte (16) zur Aufnahme einer zumindest die elektrische Spannung zwischen den Kontakten auswertenden integrierten Schaltung (12) gebildet sind, und/oder dass die elektrischen Kontakte (16) mit der integrierten Schaltung (12) verlötet sind.

10. Kraftfahrzeugbatteriesensorelement nach einem der vorangehenden Ansprüche, **dadurch gekennzeichnet, dass** die elektrischen Kontakte (16) einen Abstand von 1mm-50mm, vorzugsweise 5mm-10mm haben.

11. Kraftfahrzeugbatteriesensorelement nach einem der vorangehenden Ansprüche, **dadurch gekennzeichnet, dass** die elektrischen Kontakte (16)

   A) im Bereich des Widerstandsstücks (6),
   B) auf den Übergängen zwischen dem Widerstandsstück (6) und den Anschlussstücken (4a, 4b), oder
   C) auf den Anschlussstücken (4a, 4b)

   angeordnet ist.

12. Verfahren zur Herstellung eines Kraftfahrzeugbatteriesensorelementes, insbesondere nach Anspruch 1, mit:

   - Anordnen zweier räumlich voneinander getrennter elektrischer Kontakte (16) auf einem Widerstandselement (2) ;
   - elektrischem Verbinden der Kontakte (16) mit dem Widerstandselement (2),
   - metallisches Beschichten der Kontakte (16) zusammen mit dem Widerstandselement (2), derart
   - dass die Thermospannung zwischen den elektrischen Kontakten (16) und dem Widerstandselement (2) über die Beschichtung (8) kurz geschlossen ist.

13. Verfahren nach Anspruch 12, **gekennzeichnet durch** Verzinnen der elektrischen Kontakte (16) zusammen mit dem Widerstandselement (2).

14. Verfahren nach einem der vorangehenden Ansprüche, **gekennzeichnet durch** metallisches Beschichten der elektrischen Kontakte (16) zusammen mit dem Widerstandselement (2) **durch** Tauchen, Galvanisieren, Pulverbeschichten.

## Claims

1. Motor vehicle battery sensor element with

   - a resistor element (2), and
   - at least two spatially separated electrical contacts (16) positioned on the resistor element (2),

   **wherein**

   - the resistor element (2) along with the electrical contacts (16) is coated with a metal coating (8), such
   - that the thermoelectric potential between the electrical contacts (16) and the resistor element (2) is shortcircuited via the coating (8).

2. Motor vehicle battery sensor element according to claim 1, **characterised in that** the coating (8) is in tin and/or that the coating (8) has a thickness of between $1\mu m$ and $10\ \mu m$.

3. Motor vehicle battery sensor element according to claim 1 or 2, **characterised in that** the thermoelectric potential between the electrical contacts (16) and the resistor element (2) is between $0.1\ \mu V/K$ and $1\ \mu V/K$ and/or that the resistor element (6) in the temperature range from 20°C to 50°C has a temperature coefficient in the range $10*10^{-6}$, and/or that the resistor element (2) has a temperature coefficient compensating the temperature coefficient of the coating (8) such that the effect of the temperature coefficient on the overall resistance is essentially compensated.

4. Motor vehicle battery sensor element according to one of the preceding claims, **characterised in that** the electrical contacts (16) are made from a non-ferrous metal, in particular copper.

5. Motor vehicle battery sensor element according to one of the preceding claims, **characterised in that** the resistor element (2) is made from two flat parts (4, 6) connected with each other together by material closure and/or that a first flat part is a resistance piece in the form of a measuring resistor (6) and a second flat part is a connection piece (4a, 4b) made from non-ferrous metal.

6. Motor vehicle battery sensor element according to one of the preceding claims, **characterised in that** the resistor element (2) is at least in part made from NiCu30Fe, CuMn12Ni, Cu,Ni30Mn, NiFe30, CuNi23Mn, CuMn7Sn, CuNi15, CuNi10, CuMn3, CuNi6, Ni99.6, Ni99.4Fe, Ni99.98, CuNi2, CuNi1, E-Cu57 or W.

7. Motor vehicle battery sensor element according to one of the preceding claims, **characterised in that** the resistor element (2) is connected with a battery pole clip by material closure and/or that the resistor element (2) is connected with a power conductor leading to consumers by material closure.

8. Motor vehicle battery sensor element according to one of the preceding claims, **characterised in that** the electrical contacts (16) are in the form of flat or round conductors positioned flat on the surface of the resistor element (2) and/or that the electrical contacts (16) are positioned essentially orthogonally to the direction of the current in the resistor element (2) on the surface (10) of the resistor element (2).

9. Motor vehicle battery sensor element according to one of the preceding claims, **characterised in that** the ends of the electrical contacts (16) are formed to accommodate an integrated circuit (12) which assesses at least the electrical voltage between the contacts and/or that the electrical contacts (16) are soldered to the integrated circuit (12).

10. Motor vehicle battery sensor element according to one of the preceding claims, **characterised in that** the electrical contacts (16) have a spatial distance of 1mm-50mm preferably 5mm - 10mm.

11. Motor vehicle battery sensor element according to one of the preceding claims, **characterised in that** the electrical contacts (16) are positioned

    A) in the area of the resistance piece (6),
    B) on the transitions between the resistance piece (6) and the connection pieces (4a, 4b), or
    C) on the connection pieces (4a, 4b).

12. Method for producing a motor vehicle battery sensor element, in particular according to claim 1 with:

    - arranging of two spatially separated electrical contacts (16) on a resistor element (2),
    - electrically connecting of the contacts (16) with the resistor element (2),
    - metal coating of the contacts (16) together with the resistor element (2), such
    - that the thermoelectric potential between the electrical contacts (16) and the resistor element (2) is shortcircuited via the coating (8).

13. Method according to claim 12, **characterised by** the tinning of the electrical contacts (16) together with the resistor element (2).

14. Method according to one of the preceding claims, **characterised by** the metal coating of the electrical contacts (16) together with the resistor element (2) by immersion, galvanisation or powder coating.

**Revendications**

1. Elément capteur de batterie de véhicule automobile, avec

    - un élément de résistance (2) et
    - au moins deux contacts électriques (16), agencés, séparés l'un de l'autre, sur un élément de résistance (2). Sachant que
    - l'élément de résistance (2) est pourvu, en commun avec l'élément de résistance (2), d'un revêtement métallique, de sorte que
    - la tension thermique soit court-circuitée entre les contacts électriques (16) et l'élément de résistance (2), par l'intermédiaire du revêtement (8).

2. Elément capteur de batterie de véhicule automobile selon la revendication 1, **caractérisé en ce que** le revêtement (8) consiste en étain et / ou que le revêtement (8) a une épaisseur de 1 $\mu$m à 10 $\mu$m.

3. Elément capteur de batterie de véhicule automobile selon revendication 1 ou 2, **caractérisé en ce que** la tension thermique entre les contacts électriques (16) et l'élément de résistance (2) est située entre 0,1 $\mu$V / K et 1 $\mu$V / K, et / ou que l'élément de résistance (6), dans une plage de température de 20 °C à 50 °C, a un coefficient de température de $10.10^{-6}$, et / ou que l'élément de résistance (2) a un coefficient de température, qui compense je coefficient de température du revêtement (8), de sorte que l'influence du coefficient de température du revêtement sur la résistance totale soit sensiblement compensée.

4. Elément capteur de batterie de véhicule automobile selon l'une des revendications précédentes, **caractérisé en ce que** les contacts électriques (16) sont réalisés en métal non ferreux, en particulier en cuivre.

5. Elément capteur de batterie de véhicule automobile selon l'une des revendications précédentes, **caractérisé en ce que** l'élément de résistance (2) est formé par deux pièces plates (4, 6), qui sont reliées ensemble par fusion de matière, et / ou qu'une première pièce plate consiste en une pièce de résistance de mesure et qu'une deuxième pièce plate est une pièce de raccordement (4a, 4b) formée en métal non ferreux.

6. Elément capteur de batterie de véhicule automobile selon l'une des revendications précédentes, **caractérisé en ce que** l'élément de résistance (2) est réalisé, au moins partiellement, en NiCu30Fe, CuMn12Ni, CuNi30Mn, NiFe30, CuNi23Mn, CuMn7Sn, CuNi15, CuNi10, CuMn3, CuNi6, Ni99,6, Ni99, 4Fe, Ni99,98, CuNi2, CuNi1, E-Cu57 ou en W.

7. Elément capteur de batterie de véhicule automobile selon l'une des revendications précédentes, **caractérisé en ce que** l'élément de résistance (2) est relié par fusion de matière à une cosse de borne de batterie et /ou que l'élément de résistance (2) est relié par fusion de matière à un conducteur d'énergie conduisant à des consommateurs.

8. Elément capteur de batterie de véhicule automobile selon l'une des revendications précédentes, **caractérisé en ce que** les contacts électriques (16) sont formés par des conducteurs agencés en nappe sur la surface de l'élément de résistance (2), des conducteurs plats ou rondes, et / ou que les contacts électriques (16) sont disposés sur la surface (10) de l'élément de résistance (2), sensiblement orthogonalement par rapport à la direction de propagation du courant.

9. Elément capteur de batterie de véhicule automobile selon l'une des revendications précédentes, **caractérisé en ce que** les extrémités des contacts électriques (16) sont conçu pour recevoir un circuit intégré (12) évaluant au moins la tension électrique entre les contacts, et / ou que les contacts électriques (16) sont brasés avec ledit circuit intégré (12).

10. Elément capteur de batterie de véhicule automobile l'une des revendications précédentes, **caractérisé en ce que** les contacts électriques (16) ont un intervalle de 1 mm à 50 mm, de préférence de 5 mm à 10 mm.

11. Elément capteur de batterie de véhicule automobile selon l'une des revendications précédentes, **caractérisé en ce que** les contacts électriques (16) sont disposés

A) dans la région de la pièce de résistance (6),
B) sur les passages entre la pièce de résistance (6) et les pièces de raccordement (4a, 4b) ou
C) sur les pièces de raccordement (4a, 4b).

12. Procédé de fabrication d'un élément capteur de batterie de véhicule automobile, en particulier selon la revendication 1, qui comprend :

- agencement de deux contacts électriques (16), séparés l'un de l'autre, sur un élément de résistance (2),
- liaison électrique entre les contacts (16) et l'élément de résistance (2),
- revêtement métallique des contacts (16) en commun avec l'élément de résistance (2) de sorte que
- la tension thermique soit court-circuitée entre les contacts électriques (16) et l'élément de résistance (2) par l'intermédiaire du revêtement (8).

13. Procédé selon la revendication 12, **caractérisé par** l'étamage des contacts électriques (16) avec l'élément de résistance (2).

14. Procédé selon l'une des revendications précédentes, **caractérisé par** le revêtement métallique des contacts électriques (16) en commun avec l'élément de résistance (2), par trempage, galvanisation, revêtement par poudre.

Fig.1a

Fig.1b

Fig.2

Fig.3

Fig.4

Fig.5

Fig.6

EP 2 165 205 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0990167 A
- DE 102004007851
- DE 102005019569
- DE 102004049153